# EUROPEAN PATENT APPLICATION

(11) **EP 4 790 905 A1**
(43) Date of publication of application: **12.08.2026**
(21) Application number: 25189955.5
(22) Date of filing: 16.07.2025
(51) Int. Cl.: H03M 13/15, G06F 11/10

(54) **MEMORY SYSTEM, CONTROLLER, AND METHOD OF CONTROLLING MEMORY**

(30) Priority: 10.02.2025 JP 2025019959
(71) Applicant: Kioxia Corporation, Tokyo 108-0023 (JP)
(72) Inventor: Uchikawa, Hironori, Tokyo 108-0023 (JP); Kondo, Yuki, Tokyo 108-0023 (JP)
(74) Representative: Marks & Clerk LLP

(57) **Abstract**

In a memory system (1), a memory (20) stores data encoded with an error-correcting code for correcting errors of t bits or less. A controller (10) calculates t syndromes by using a received word read from the memory (20). The controller (10) executes variable transformation on the syndromes to calculate (t-1) pieces of key information for determining a first error pattern including a combination of post-transformation positions acquired by performing the variable transformation on error positions in a case of the number of error bits being (t+1). The controller (10) determines the first error pattern corresponding to the key information by using correspondence information, and calculates error positions by executing variable inverse transformation on the post-transformation positions included in the first error pattern. The controller (10) determines a list including a second error pattern including a combination of the error positions and executes list decoding by using the list.

## Description

### FIELD

Embodiments described herein relate generally to a memory system, a controller, and a method of controlling a memory.

### BACKGROUND

In a memory system, for protecting data stored in a memory such as a NAND flash memory, error-correction-encoded data is stored in the memory.

When the data stored in the memory is read, the error-correction-encoded data that is read from the memory (also referred to as a received word) is decoded to restore data before the error correction encoding.

### BRIEF DESCRIPTION OF THE DRAWINGS

FIG. 1 is a block diagram of a memory system according to an embodiment;
FIG. 2 is a block diagram of a decoding unit according to a first embodiment;
FIG. 3 is a flowchart of decoding processing according to the embodiment;
FIG. 4 is a flowchart of decoding processing according to a modification;
FIG. 5 is a diagram illustrating a configuration example of a root calculation circuit according to the first embodiment;
FIG. 6 is a diagram illustrating an example of a pseudo code of a function of determining an error pattern;
FIG. 7 is a diagram illustrating a configuration example of a root calculation circuit according to a second embodiment;
FIG. 8 is a diagram illustrating an example of a lookup table;
FIG. 9 is a diagram illustrating an example of a lookup table;
FIG. 10 is a diagram illustrating an example of a lookup table;
FIG. 11 is a diagram illustrating an example of a pseudo code of a function of determining an error pattern; and
FIG. 12 is a diagram illustrating an example of a pseudo code of a function of determining an error pattern.

### DETAILED DESCRIPTION

A memory system according to an embodiment includes a memory and a controller. The memory is configured to store data having been encoded with an error-correcting code for correcting an error of t bits or less (t is an integer of 2 or more). The controller is configured to read a received word from the memory. The controller is configured to calculate at least t syndromes by using the read received word. The controller is configured to calculate, by executing variable transformation on the calculated syndrome, (t-1) pieces of key information for determining one or more first error patterns each including a combination of post-transformation positions. The post-transformation positions are acquired by applying the variable transformation to error positions in a case of the number of error bits being (t+1) . The controller is configured to determine the one or more first error patterns corresponding to the calculated key information by using correspondence information in which possible values for the key information and the one or more first error patterns are correlated with each other. The controller is configured to calculate the error positions by executing variable inverse transformation on the post-transformation positions included in each of the one or more first error patterns. The controller is configured to determine a list including one or more second error patterns. The second error patterns are each including a combination of the calculated error positions. The controller is configured to execute list decoding by using the list.

Hereinafter, a preferred embodiment of the memory system according to the present invention will be described in detail with reference to the accompanying drawings.

### (First embodiment)

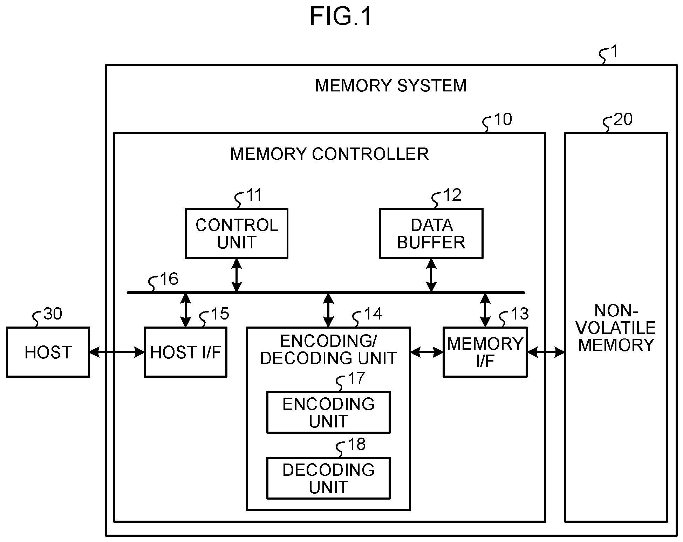

First, the memory system according to the present embodiment will be described in detail with reference to the drawings. FIG. 1 is a block diagram illustrating a schematic configuration example of a memory system according to the present embodiment. As illustrated in FIG. 1, the memory system 1 includes a memory controller 10 and non-volatile memory 20. The memory system 1 can be connected to a host 30, and FIG. 1 illustrates the memory system 1 connected to the host 30. The host 30 may be, for example, an electronic device such as a personal computer or a mobile terminal.

The non-volatile memory 20 is non-volatile memory that stores data in a non-volatile manner, and is, for example, NAND flash memory (hereinafter, simply referred to as NAND memory). In the following description, the NAND memory is used as the non-volatile memory 20, but a storage device other than the NAND memory, such as three-dimensional structure flash memory, resistive random access memory (ReRAM), or ferroelectric random access memory (FeRAM), can be used as the non-volatile memory 20. In addition, the non-volatile memory 20 is not necessarily a semiconductor memory, and the present embodiment can also be applied to various storage media other than the semiconductor memory.

The memory system 1 may be various memory systems including the non-volatile memory 20, such as a so-called solid state drive (SSD) or a memory card in which the memory controller 10 and the non-volatile memory 20 are configured as one package.

The memory controller 10 controls writing to the non-volatile memory 20 in accordance with a write request from the host 30. The memory controller 10 controls reading from the non-volatile memory 20 in accordance with a read request from the host 30. The memory controller 10 is, for example, a semiconductor integrated circuit configured as a system on a chip (SoC). The memory controller 10 includes a host interface (host I/F) 15, a memory interface (memory I/F) 13, a control unit 11, an encoding/decoding unit (CODEC) 14, and a data buffer 12. The host I/F 15, the memory I/F 13, the control unit 11, the encoding/decoding unit 14, and the data buffer 12 are mutually connected by an internal bus 16. Some or all of operations of each component of the memory controller 10 described below may be implemented by a central processing unit (CPU) executing firmware or may be implemented by hardware.

The host I/F 15 is a circuit that performs processing according to an interface standard with the host 30, and outputs a command received from the host 30, user data to be written, and the like to the internal bus 16. In addition, the host I/F 15 transmits user data read from the non-volatile memory 20 and restored, a response from the control unit 11, and the like to the host 30.

The memory I/F 13 is a circuit that performs write processing to the non-volatile memory 20 based on an instruction from the control unit 11. The memory I/F 13 performs read processing from the non-volatile memory 20 based on the instruction from the control unit 11. The memory I/F13 may be an interface compliant to any standard, and is, for example, an interface compliant to a toggle double data rate (Toggle DDR) standard or an open NAND flash interface (ONFI) standard.

The control unit 11 integrally controls each component of the memory system 1. The control unit 11 may be implemented by causing a processor such as a CPU and a graphics processing unit (GPU) to execute a computer program, namely, implemented by software. The control unit 11 may be implemented by a processor such as a dedicated integrated circuit (IC), namely, implemented by hardware. The control unit 11 may be implemented by software and hardware in combination. When a command is received from the host 30 via the host I/F 15, the control unit 11 performs control according to the command. For example, the control unit 11 instructs the memory I/F 13 to write the user data and a parity to the non-volatile memory 20 in accordance with a command from the host 30. The control unit 11 instructs the memory I/F 13 to read the user data and the parity from the non-volatile memory 20 in accordance with a command from the host 30.

When a write request is received from the host 30, the control unit 11 determines a storage area (memory area) on the non-volatile memory 20 for the user data accumulated in the data buffer 12. That is, the control unit 11 manages a write destination of the user data. The correspondence between the logical address of the user data received from the host 30 and the physical address indicating the storage area on the non-volatile memory 20 storing the user data is stored as an address transformation table.

When a read request is received from the host 30, the control unit 11 transforms a logical address designated by the read request into a physical address by using the above-described address transformation table, and instructs the memory I/F 13 to perform reading from the physical address.

In the NAND memory, writing and reading are generally performed in data units called pages, and erasing is performed in data units called blocks. In the present embodiment, a plurality of memory cells connected to the same word line is referred to as a memory cell group. When the memory cell is a single level cell (SLC), one memory cell group corresponds to one page. When the memory cell is a multiple level cell (MLC), one memory cell group corresponds to a plurality of pages. In the present description, the MLC includes a triple level cell (TLC), a quad level cell (OLC), and the like. Each memory cell is connected to the word line and is also connected to a bit line. Therefore, each memory cell can be identified by an address for identifying the word line and an address for identifying the bit line.

The data buffer 12 temporarily stores the user data received from the host 30 by the memory controller 10 until the user data is stored in the non-volatile memory 20. In addition, the data buffer 12 temporarily stores the user data read from the non-volatile memory 20 until the user data is transmitted to the host 30. As the data buffer 12, for example, general-purpose memory such as static random access memory (SRAM) or dynamic random access memory (DRAM) can be used. Note that the data buffer 12 may be installed outside the memory controller 10 instead of being built in the memory controller 10.

The user data transmitted from the host 30 is transferred to the internal bus 16 and temporarily stored in the data buffer 12. The encoding/decoding unit 14 encodes the user data to be stored in the non-volatile memory 20 and generates a code word. In addition, the encoding/decoding unit 14 decodes the received word read from the non-volatile memory 20 and restores the user data. Therefore, the encoding/decoding unit 14 includes an encoding unit (encoder) 17 and a decoding unit (decoder) 18. Note that the data encoded by the encoding/decoding unit 14 may include control data or the like used inside the memory controller 10 in addition to the user data.

Next, the write processing of the present embodiment will be described. The control unit 11 instructs the encoding unit 17 to encode the user data during writing to the non-volatile memory 20. At that time, the control unit 11 determines a storage location (storage address) of the code word in the non-volatile memory 20, and also instructs the memory I/F 13 on the determined storage location.

The encoding unit 17 encodes the user data on the data buffer 12 based on the instruction from the control unit 11 and generate a code word. As the encoding method, for example, an encoding method using an algebraic code such as a Bose-Chaudhuri-Hocquenghem (BCH) code and a Reed-Solomon (RS) code, and an encoding method (product code or the like) using these codes as component codes in the row direction and the column direction can be employed. The memory I/F 13 performs control to store the code word in the storage location on the non-volatile memory 20 instructed from the control unit 11. Hereinafter, a case of using a BCH code in which the number of bits that can be error-corrected (correction capability) is t (t is an integer of 2 or more) will be described as an example.

Next, processing during reading from the non-volatile memory 20 of the present embodiment will be described. The control unit 11 designates an address on the non-volatile memory 20 and instructs the memory I/F 13 to perform reading during reading from the non-volatile memory 20. In addition, the control unit 11 instructs the decoding unit 18 to start decoding. The memory I/F 13 reads the received word from a designated address of the non-volatile memory 20 in accordance with the instruction of the control unit 11, and inputs the read received word to the decoding unit 18. The decoding unit 18 decodes the received word read from the non-volatile memory 20.

The decoding unit 18 decodes the received word read from the non-volatile memory 20. The decoding unit 18 implements processing of correcting errors for which the number of errors (the number of error bits) exceeds the correction capability with a simpler configuration. When the BCH code whose correction capability is t is used, it is possible to correct errors at (t+1) error positions in a case of the number of error bits being (t+1) in the present embodiment. Hereinafter, a case of t being 2 will be described as an example, but a similar procedure can be applied also to a case of t being 3 or more.

Here, a technique for correcting errors in which the number of errors exceeds the correction capability of the error-correcting code will be described. For example, in soft decision decoding using reliability information for each bit, called Chase decoding, patterns indicating candidates of error position satisfying a syndrome calculated from the received word (hereinafter, error patterns) are listed, and a likely error pattern is selected from among the error patterns to perform error correction. In this technique, error patterns including a number of error positions, the number of which exceeds the correction capability of the error-correcting code, may be listed. Each of the error patterns is information including a combination of two or more (for example, three) error positions.

One technique for such a case is to determine the error positions by flipping some of bits and recalculate the syndrome (hereinafter, "comparative example"). For example, in a case where an error pattern including three (three bits of) error positions is determined for a BCH code whose correction capability is two bits, if an error at one error position among the three error positions is corrected by bit flipping, the remaining number of errors is two. Therefore, two error positions can be calculated from the syndrome.

In the technique for listing error patterns by using bit flipping as in the above-described comparative example, error correction processing is executed for each syndrome recalculated after bit flipping. Therefore, it is necessary to execute the error correction processing for the number of target bit flips, and thus decoding may not be able to be executed at high speed.

In the present embodiment, without executing bit flipping as in the comparative example for the BCH code whose correction capability is two bits, error patterns indicating three (three bits of) error positions are listed, and list decoding using the list including the listed error patterns is executed. In the present embodiment, the error patterns can be listed in one decoding processing using a lookup table (LUT, an example of corresponding information) for determining the error patterns.

One conceivable simple method using the lookup table is to determine an error pattern corresponding to the key information by using the syndrome as key information without any changes. However, in such a method, the number of entries is excessive, which may result in an excessive data amount (size) in the lookup table. Therefore, in the present embodiment, the data amount in the lookup table is reduced by performing variable transformation on the syndrome. As a result, error correction (decoding) can be executed with a simpler configuration. Hereinafter, the details the decoding unit 18 of the present embodiment will be described.

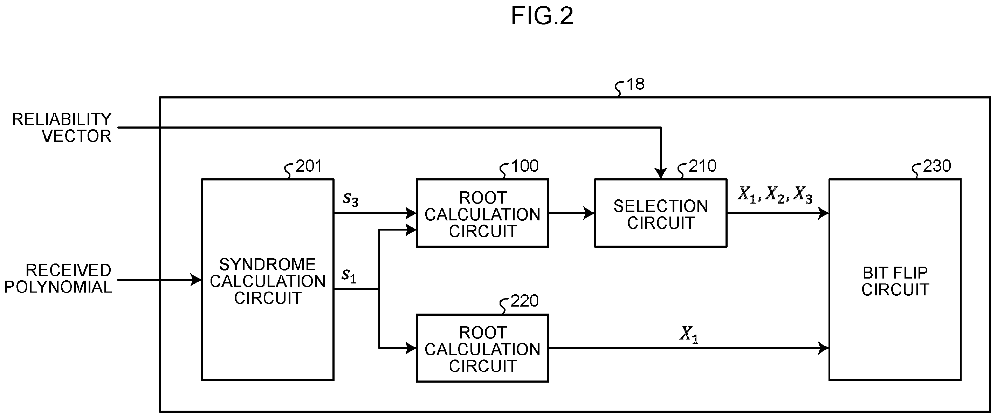

FIG. 2 is a block diagram illustrating a configuration example of the decoding unit 18 according to the present embodiment. FIG. 2 illustrates an example of a case where the decoding unit 18 is implemented by a hardware circuit. As illustrated in FIG. 2, the decoding unit 18 includes a syndrome calculation circuit 201, a root calculation circuit 100, a selection circuit 210, a root calculation circuit 220, and a bit flip circuit 230.

A received word R input to the decoding unit 18 is, for example, a vector having a log-likelihood ratio (LLR) as an element and having the same length as a code length n (n is an integer of 2 or more). A received polynomial r(x) including bits corresponding to positive and negative signs of the element LLR of the received word R is input to the syndrome calculation circuit 201, and a reliability vector l having a length n including an absolute value of the element LLR is input to the selection circuit 210.

The syndrome calculation circuit 201 receives the received polynomial r(x) and calculates and outputs the syndrome. The received polynomial r(x) is a polynomial having bits corresponding to positive and negative signs of the element LLR as coefficients, and is defined by the following formula (1). The received polynomial r(x) is, for example, r₋ₖ=0 when the k-th LLR is positive and r₋ₖ=1 when the k-th LLR is negative. ${\sum }_{k = 0}^{n - 1} {r}_{k} {x}^{k}$

In one example, the syndrome calculation circuit 201 calculates a syndrome sᵢ from sᵢ:=r(αⁱ). The received polynomial is r(x)=c(x)+e(x) based on the additivity of errors. Note that c(x) is a polynomial representing a code word, and e(x) is a polynomial representing an error. e(x) may be referred to as an error polynomial. α represents the primitive (2^{m}-1)-th root of GF(2^{m}). When a BCH code whose correction capability is 2 bits is used, the syndrome calculation circuit 201 receives the received polynomial r(x) and outputs syndromes s₁ and s₃. The syndromes s₁ and s₃ correspond to syndromes corresponding to the sum of first powers and the sum of cubes of the primitive element α of a Galois field GF, respectively.

The root calculation circuit 100 calculates error patterns including error position candidates when the number of errors is two or three. The method of calculating the error patterns in a case of the number of errors being two may be any conventionally used method, but, for example, the method described in Patent Document JP 2023-045450 A can be applied.

The error pattern is defined by a binary vector e^{(v)} that v number of elements corresponding to the number of errors have a value of 1, and the other elements each have a value of 0. The binary vector e^{(v)} has the same length as the code length n. Note that the format of the error pattern is not limited to the binary vector. For example, the error pattern may be expressed by a tuple having an integral error position index.

Hereinafter, the error pattern defined by the binary vector e^{(v)} may be referred to as an error pattern e^{(v)}. The error pattern e^{(v)} in a case of the number of errors being one or two, namely, the error pattern e⁽¹⁾ and the error pattern e⁽²⁾ are each one. The error pattern e^{(v)} in a case of the number of errors being three, namely, the error pattern e⁽³⁾ is one or more. Hereinafter, the i-th (i is an integer of 1 or more) error pattern e^{(v)} may be represented by eᵢ^{(v)}.

The root calculation circuit 100 determines one error pattern (e⁽²⁾) in a case of the number of errors being two, and includes the determined one error pattern in the list. When the number of errors is two, the error pattern includes a combination of two error positions. Hereinafter, the combination of two error positions may be referred to as (X₁, X₂).

The root calculation circuit 100 calculates one or more error patterns e⁽³⁾ (second error pattern) in a case of the number of errors being three, for example, by the following procedure.

The root calculation circuit 100 calculates two pieces of key information for determining one or more error patterns e_{A} (first error pattern), for example, by executing variable transformation on the calculated syndrome. The error patterns e_{A} are error patterns each including a combination of post-transformation positions determined by applying variable transformation to the three error positions X₁, X₂, and X₃. The variable transformation is, for example, an affine transformation, and transformation that can reduce the data amount in the lookup table is applied. Details of the variable transformation will be described later.

Note that there is a case where one of the three error positions can be calculated from the remaining two error positions. For example, the error position X₃ can be calculated by arithmetic operation using the error positions X₁ and X₂. In such a case, the error pattern e_{A} may be an error pattern including a combination of two post-transformation positions. Hereinafter, an example of using the error patterns e_{A} including a combination of the two post-transformation positions (X^₁, X^₂) will be mainly described. Note that X^ corresponds to a variable with a hat on X.

The root calculation circuit 100 determines one or more error patterns e_{A} corresponding to the calculated key information by using the lookup table. The lookup table corresponds to correspondence information in which possible values for the key information are correlated with the one or more error patterns e_{A}.

The root calculation circuit 100 calculates error positions X by executing inverse transformation of the variable transformation (variable inverse transformation) on the post-transformation positions included in each of the one or more error patterns e_{A}. The root calculation circuit 100 calculates one or more error patterns e⁽³⁾ each including a combination of the calculated error positions X. When the number of errors is three, the error pattern e⁽³⁾ includes a combination of three error positions (X₁, X₂, X₃). The root calculation circuit 100 determines a list including the calculated error patterns e⁽³⁾.

The selection circuit 210 selects a likely error pattern (hereinafter, the maximum likelihood error pattern) from the one or more error patterns included in the list, and outputs error positions included in the selected maximum likelihood error pattern. When the error pattern e⁽²⁾ in a case of the number of errors being two is selected as the maximum likelihood error pattern, the selection circuit 210 outputs the error positions X₁ and X₂. When the error pattern e⁽³⁾ in a case of the number of errors being three is selected as the maximum likelihood error pattern, the selection circuit 210 outputs the error positions X₁, X₂, and X₃.

The selection circuit 210 selects the maximum likelihood error pattern e* by using the following formula (2). ${e}^{*} = {argmin}_{{e}_{i}^{\left(v\right)}} L \left({e}_{i}^{\left(v\right)}\right)$

Here, L(eᵢ^{(v)}) represents a score function that returns a score of a real number or an integer from the error pattern eᵢ^{(v)} and reliability information of each bit. The score is information indicating the reliability of being an error position, and for example, a smaller value indicates being closer to a true error. The formula (2) represents that the error pattern having the smallest score is selected as the maximum likelihood error pattern e*. That is, the selection circuit 210 selects, as the maximum likelihood error pattern e*, an error pattern having a larger reliability of being the error position than the other error patterns.

Note that the score of the formula (2) is an example, and any other evaluation value may be used. For example, an evaluation value that is closer to the true error as the value becomes larger may be used.

The reliability information for each bit is, for example, a positive value of 0 or more, and a larger value indicates higher reliability. As the reliability information, an absolute value of a log-likelihood ratio may be used. When a reliability vector having reliability information lⱼ of the j-th bit (j is an integer satisfying 1≤j≤n,) as an element is l, the score function L(eᵢ^{(v)}) is defined by the following formula (3). Note that the operator "." represents an inner product of vectors. $L \left({e}_{i}^{\left(v\right)}\right) = l ⋅ {e}_{i}^{\left(v\right)}$

In a system in which the code length is dynamically changed (also referred to as a shortening code, and in which a data length to be encoded is changed), the selection circuit 210 rejects an error pattern indicating an error position larger than the code length of the received word.

The root calculation circuit 220 calculates the error position X₁ when the number of errors is one. The root calculation circuit 220 calculates an error pattern e⁽¹⁾ in a case of the number of errors being one. The root calculation circuit 220 sets the error pattern e⁽¹⁾ as the maximum likelihood error pattern and outputs the error position X₁ included in the maximum likelihood error pattern. The method of calculating the error patterns in a case of the number of errors being one may be any conventionally used method, but for example, the above-mentioned method described in Patent Document JP 2023-045450 A can be applied.

The number of errors can be estimated as follows by using the value of the syndrome. The number of errors and the value of the syndrome have the following relationship.
- s₁³=s₃ when the number of errors is zero or one
- s₁³≠s₃ when the number of errors is two or three

Therefore, assuming that the number of errors is three or less, the number of errors is zero or one when (s₁³=s₃).

Here, when β:=s₁³+s₃, β=0 is equivalent to s₁³=s₃. Therefore, when β is used, the following relationship is determined for the number of errors.
- Assuming that the number of errors is three or less, the number of errors is zero or one when (β=0). Further, the number of errors is zero when (β=0 and) s₁=0.

The bit flip circuit 230 receives the received polynomial r(x) and the error position output by the selection circuit 210 or the root calculation circuit 220, and outputs a received word with the bit of the error position inverted. Note that, here, the received word is the output of the decoding unit 18, but the output of the decoding unit 18 is not limited to the received word. The format of the output of the decoding unit 18 may be changed according to the system to be configured, such as by outputting the error polynomial, the error position, or payload data excluding redundant data for error correction after inverting the bit of the error position.

The list decoding refers to the processing of selecting the maximum likelihood error pattern at the selection circuit 210 by using the list of the error patterns determined by the root calculation circuit 100, and inverting the bit of the error position included in the maximum likelihood error pattern at the bit flip circuit 230.

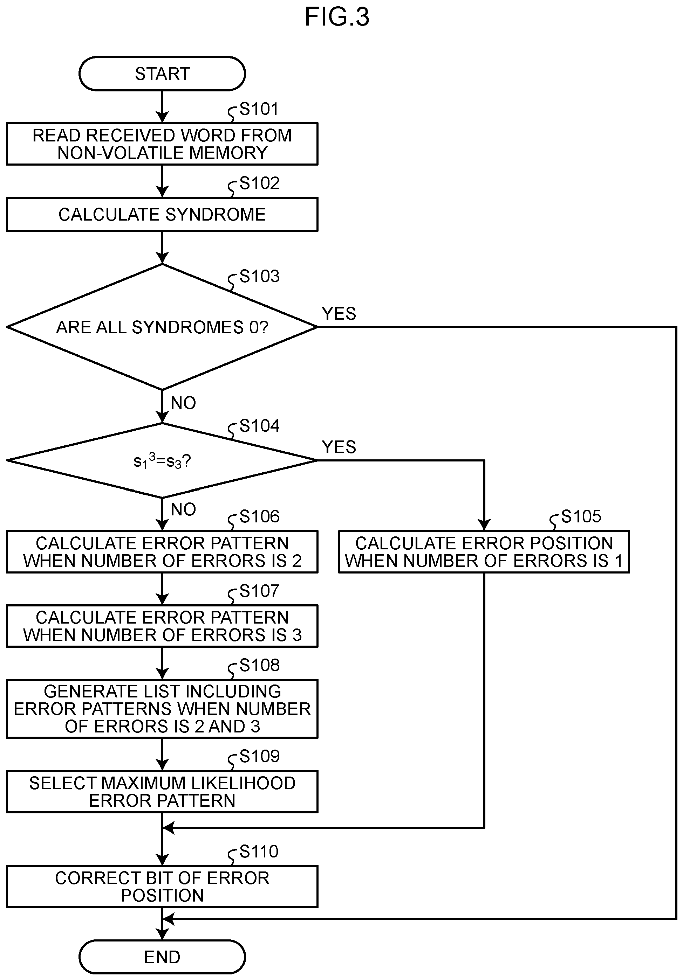

Next, a procedure of decoding processing by the memory system 1 will be described. FIG. 3 is a flowchart illustrating an example of decoding processing according to the present embodiment.

The control unit 11 reads the error-correcting code from the non-volatile memory 20, and determines the received word (step S101). In addition, the control unit 11 instructs the decoding unit 18 to start decoding.

The syndrome calculation circuit 201 of the decoding unit 18 calculates the syndrome from the received word (received polynomial r(x)) (step S102). The syndrome calculation circuit 201 calculates the syndromes s₁ and s₃.

The decoding unit 18 determines whether or not the values of all the syndromes (syndromes s₁ and s₃) are 0 (step S103). When all the syndromes are 0 (step S103: Yes), the decoding processing ends. This is because, when all the syndromes are 0, it can be determined that there are no errors in the received word.

When all the syndromes are not 0 (step S103: No), the decoding unit 18 determines whether or not s₁³=s₃ is satisfied (step S104). The determination as to whether s₁³=s₃ is satisfied as described above corresponds determination as to whether the number of errors is one. When s₁³=s₃ is not satisfied, it means that the number of errors is two or three.

When s₁³=s₃ is satisfied (namely, the number of errors is one) (step S104: Yes), the root calculation circuit 220 calculates the error position X₁ in a case of the number of errors being one (step S105).

When s₁³=s₃ is not satisfied (namely, the number of errors is two or three) (step S104: No), the root calculation circuit 100 calculates one error pattern in a case of the number of errors being two (step S106). In addition, the root calculation circuit 100 calculates one or more error patterns in a case of the number of errors being three (step S107). The root calculation circuit 100 generates a list that includes the error pattern in the case of the number of errors being two and the error patterns in the case of the number of errors being three (step S108). Note that steps S106 and S107 may be executed in the reverse order or may be executed in parallel.

The selection circuit 210 selects the maximum likelihood error pattern from among the one or more error patterns included in the generated list (step S109).

The bit flip circuit 230 corrects the bit of the error position(step S110). For example, when the number of errors is two or three, the bit flip circuit 230 performs correction by flipping the bits of the error positions included in the maximum likelihood error pattern selected by the selection circuit 210. When the number of errors is one, the bit flip circuit 230 performs correction by flipping the bit of the error position X₁ calculated by the root calculation circuit 220.

As described above, FIG. 3 illustrates an example in which the list including both the error pattern in the case of the number of errors being two and the error patterns in the case of the number of errors being three is generated to execute list decoding. Such an example can be applied to a case where the number of errors cannot be determined to be two or three.

### (Modification)

A modification for a case where the number of errors can be determined to be two or three will be described. For example, the extended BCH code can calculate a syndrome s₀ in addition to the syndromes s₁ and s₃. The syndrome s₀ is 0 when the number of errors is an even number, and is 1 when the number of errors is an odd number. In the modification, the syndrome calculation circuit 201 receives the received polynomial r(x) and calculates and outputs the syndromes s₀, s₁, and s₃.

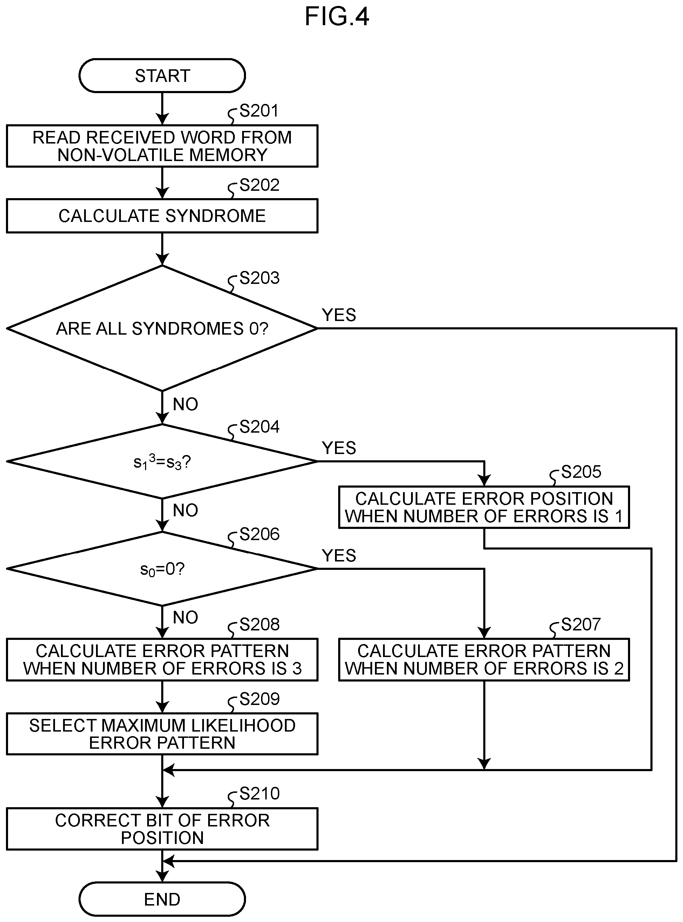

FIG. 4 is a flowchart illustrating an example of decoding processing according to the modification. Steps S201 and S203 to S205 are the same as steps S101 and S103 to S105 in FIG. 3, and thus the description thereof is omitted.

In step S202, the syndrome calculation circuit 201 receives the received polynomial r(x) and calculates and outputs the syndromes s₀, s₁, and s₃ (step S202).

In the modification, when s₁³=s₃ is not satisfied (the number of errors is two or three) (step S204: No), the decoding unit 18 further determines whether or not s₀=0 is satisfied (step S206). Determining whether or not s₀=0 is satisfied as described above corresponds to determining whether or not the number of errors is two (even number).

When s₀=0 is satisfied (the number of errors is two) (step S206: Yes), the root calculation circuit 100 calculates one error pattern in the case of the number of errors being two (step S207). In this case, since it is known that the number of errors is two, the error pattern can be used as the maximum likelihood error pattern.

When s₀=0 is not satisfied (the number of errors is three) (step S206: No), the root calculation circuit 100 calculates one or more error patterns in the case of the number of errors being three (step S208). In the modification, the root calculation circuit 100 generates a list including the error patterns in the case of the number of errors being three.

The selection circuit 210 selects the maximum likelihood error pattern from among the one or more error patterns included in the generated list (step S209).

The bit flip circuit 230 corrects the bit of the error position(step S210). For example, when the number of errors is three, the bit flip circuit 230 performs correction by flipping the bits of the error positions included in the maximum likelihood error pattern selected by the selection circuit 210. When the number of errors is one, the bit flip circuit 230 performs correction by flipping the bit of the error position X₁ calculated by the root calculation circuit 220. When the number of errors is two, the bit flip circuit 230 performs correction by flipping the bits of two error positions included in the one error pattern calculated by the root calculation circuit 100 in step S207 in the case of the number of errors being two.

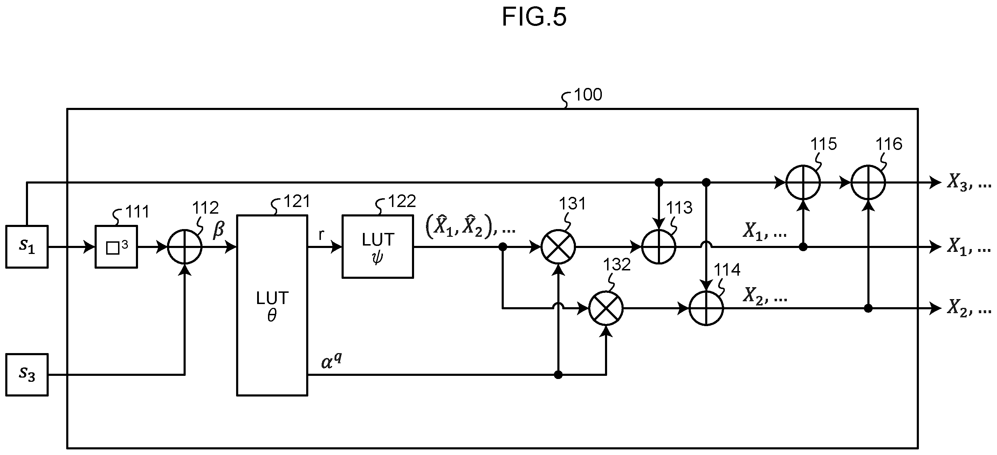

Next, a configuration example of the root calculation circuit 100 will be described. FIG. 5 is a diagram illustrating the configuration example of the root calculation circuit 100.

The root calculation circuit 100 includes arithmetic circuits 111, 112, 113, 114, 115, and 116, lookup tables (LUTs) 121 and 122, and arithmetic circuits 131 and 132.

Each unit in the root calculation circuit 100 executes the following arithmetic operation.
- Arithmetic circuit 111: Output the cube of the syndrome s₁.
- Arithmetic circuit 112: Add the output value of the arithmetic circuit 111 and the syndrome s₃, and output β (= s₁³+s₃) that is an addition result.
- LUT 121: Output r and α¹ corresponding to β by using β as the key information.
- LUT 122: Output the one or more error patterns e_{A} corresponding to r, by using r output from the LUT 121 as the key information. Each of the one or more error patterns e_{A} includes the combination of the post-transformation positions (X^₁, X^₂).
- Arithmetic circuit 131: Multiply the post-transformation position X^₁ included in the error pattern e_{A} output from the LUT 122 by α^{q} output from the LUT 121, and output α^{q}X^₁ that is a multiplication result.
- Arithmetic circuit 132: Multiply the post-transformation position X^₂ included in the error pattern e_{A} output from the LUT 122 by α^{q} output from the LUT 121, and output α^{q}X^₂ that is a multiplication result.
- Arithmetic circuit 113: Add the output value of the arithmetic circuit 131 and the syndrome s₁, and output the addition result as an error position X₁ (= α^{q}X^₁+s₁).
- Arithmetic circuit 114: Add the output value of the arithmetic circuit 132 and the syndrome s₁, and output the addition result as an error position X₂ (= α^{q}X^₂+s₁).
- Arithmetic circuit 115: Add the output value of the arithmetic circuit 113 and the syndrome s₁, and output an addition result X₁+s₁.
- Arithmetic circuit 116: Add the output value X₁+s₁ of the arithmetic circuit 115 and the output value X₂ of the arithmetic circuit 114, and output the addition result as an error position X₃ (= X₁+X₂+s₁).

The LUT 121 and the LUT 122 correspond to correspondence information in which the possible values for the key information β are correlated with the one or more error patterns e_{A}. Hereinafter, the LUT 121 may be referred to as a table θ, and the LUT 122 may be referred to as a table ψ.

α^{q} and r are each an element on the Galois field GF and an integer from 0 to 2. α^{q} and r are calculated in advance so as to obtain β=α^{3q+r}, One value is determined for each of α^{q} and r in accordance with the value of β. A pair of α^{q} and r corresponds to one error pattern list. The one error pattern list is a list including one or more error patterns.

As described above, variable transformation that can reduce the data amount in the lookup table is used. For example, variable transformation in which the value of r is three values from 0 to 2 is used. Hereinafter, an example of variable transformation will be described.

When elements on the Galois field GF having a size of 2^{m} corresponding to three error positions are X₁, X₂, and X₃, the syndromes s₁ and s₃ are defined by the following formula (4). ${s}_{1} = {\sum }_{i = 1}^{3} {X}_{i} , {s}_{3} = {\sum }_{i = 1}^{3} {X}_{i}^{3}$

If assuming that the error position is determined from these syndromes s₁ and s₃ in the lookup table, the number of pieces of key information as an argument in the lookup table becomes 2^{2m}-1. Thus, the lookup table in such a case is required to include an enormous number of entries.

In the present modification, variable transformation (affine transformation) shown in the following formula (5) is applied to the error position Xᵢ (i=1,2,3). When this variable transformation is applied, the syndromes s₁ and s₃ are transformed into s^₁ and s^₃ shown in the following Formula (6). ${\hat{X}}_{i} = {AX}_{i} + B$ $\begin{matrix}{\hat{s}}_{1} = {\sum }_{i = 1}^{3} {\hat{X}}_{i} = {As}_{1} + B , \\ {\hat{s}}_{3} = {\sum }_{i = 1}^{3} {\hat{X}}_{i}^{3} = {\sum }_{i = 1}^{3} {A}^{3} {X}_{i}^{3} + {A}^{2} {BX}_{i}^{2} + {AB}^{2} {X}_{i} + {B}^{3} \\ = {A}^{3} {s}_{3} + {A}^{2} {Bs}_{1}^{2} + {AB}^{2} {s}_{1} + {B}^{3}\end{matrix}$

When P=As₁, the formula (6) is rewritten by the following formula (7). $\begin{matrix}{\hat{s}}_{1} = 0 \\ {\hat{s}}_{3} = {A}^{3} \left({s}_{3}+{s}_{1}^{3}\right)\end{matrix}$

As shown in the formula (7), s^₁ is 0, and thereby the variable-transformed error position X^ᵢ can be characterized only by s^₃. Thus, the key information of the lookup table can be a value based only on s^₃. Moreover, when s₁³+s₃=α^{3q+r}, the syndrome s^₃ can be expressed as s^₃=α^{r} by setting A=α^{-q}. In other words, the variable-transformed error position X^ᵢ can be characterized only by the exponent r.

Therefore, it is possible to list the error patterns e_{A} that are the patterns of the error position X^ᵢ by referring to the lookup table that correlates the error position X^ᵢ by using the exponent r, which is the value that can identify S^₃=α^{r} variable-transformed with A=α^{-q} and B=As₁, as the key information.

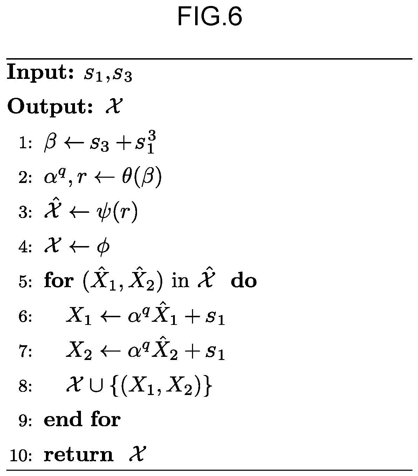

FIG. 6 is a diagram illustrating an example of a pseudo code corresponding to a function of determining an error pattern including the combination (X₁, X₂) of the error positions X₁ and X₂ from the syndromes s₁ and s₃, among the functions of the root calculation circuit 100.

In FIG. 6, θ(β) in the second line is a function that calculates α¹ and r when β=s₁³+s₃-α^{3q+r}, and corresponds to the LUT 121 (table θ).

ψ(r) in the third line is a function that outputs one or more error patterns e_{A} (a list of the error patterns e_{A}) including the combination of the post-transformation positions (X^₁,X^₂) in response to the input r, and corresponds to the LUT 122 (table ψ).

In the fifth to ninth lines, the variable inverse transformation is executed on the post-transformation positions X^₁ and X^₂ for each of the one or more error patterns e_{A}, and thereby the error positions X₁ and X₂ are restored. The error pattern including the combination (X₁, X₂) of the restored error positions X₁ and X₂ is added to the output of the pseudo code (list of error patterns). The variable inverse transformation is defined by Xᵢ =(Xᵢ^+B)/A =α^{q}×Xᵢ^+s₁ as illustrated in the sixth and seventh lines in FIG. 6.

Each entry in the table θ includes α^{q}∈GF(2^{m}) and re{0,1,2}. Therefore, the data amount per entry is m+2 bits, and thus even if the number of entries increases, the data amount in the table θ does not become excessive.

On the other hand, each entry in the table ψ includes the combination of the one or more error positions (error pattern). Therefore, the number of entries may be about the number of combinations of three selected from among 2^{m}-1 entries, C(2^{m}-1,3). In addition, the data amount of one error pattern is simply 3 m bits. If the number of entries or the data amount of each entry can be reduced, the overall data amount in the table ψ can be further reduced. Details of the function of reducing the data amount will be described after a second embodiment.

### (Second embodiment)

The second embodiment using variable transformation different from the above will be described. In the present embodiment, affine transformation X^=X+s₁ is used as the variable transformation. This variable transformation corresponds to variable transformation in the formula (5) where A=1 and B=s₁.

In the present embodiment, the root calculation circuit 100 of the first embodiment is replaced with a root calculation circuit 100-2. Other configurations are the same as those of the first embodiment, and thus the description thereof will be omitted.

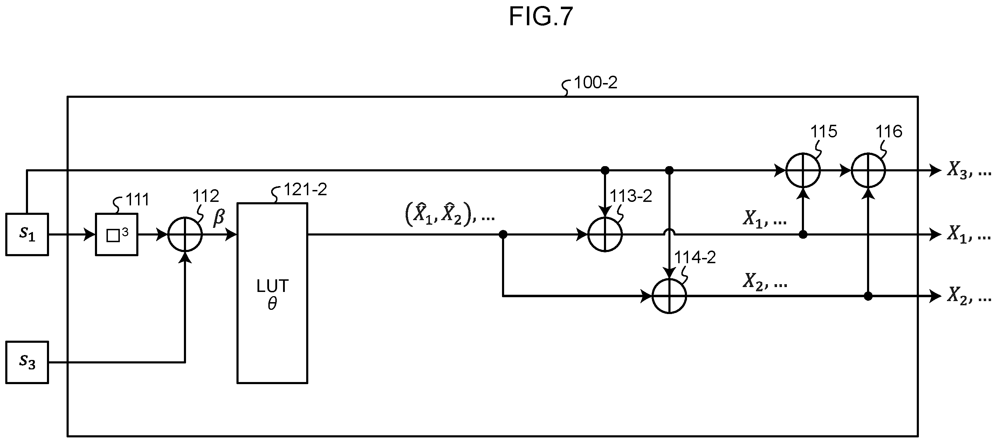

FIG. 7 is a diagram illustrating a configuration example of the root calculation circuit 100-2. The root calculation circuit 100-2 includes arithmetic circuits 111, 112, 113-2, 114-2, 115, and 116 and an LUT 121-2.

The root calculation circuit 100-2 is different from the root calculation circuit 100 of the first embodiment in that the functions of the arithmetic circuits 113-2 and 114-2 and the LUT 121-2 are provided and the arithmetic circuits 131 and 132 are deleted. The same configurations as those of the first embodiment are denoted by the same reference numerals, and description thereof will be omitted.

The arithmetic circuits 113-2 and 114-2 and the LUT 121-2 execute the following arithmetic operations.
- LUT 121-2: Output the one or more error patterns e_{A} corresponding to β by using β as the key information. Each of the one or more error patterns e_{A} includes the combination of the post-transformation positions (X^₁,X^₂).
- Arithmetic circuit 113-2: Add the post-transformation position X^₁ and the syndrome s₁ in the output of the LUT 121-2, and output the addition result as the error position X₁(=X^₁+s₁).
- Arithmetic circuit 114-2: Add the post-transformation position X^₂ and the syndrome s₁ in the output of the LUT 121-2, and output the addition result as the error position X₂(=X^₂+s₁).

An outline of a processing procedure of the root calculation circuit 100-2 will be described below.
- Calculate β=s₁³+s₃.
- By using β as the key information, determine the error pattern e_{A} for the calculated β from the LUT 121-2 that outputs the one or more error patterns e_{A} (combination of post-transformation positions (X^₁,X^₂)).
- Add s₁ to X^₁ and X^₂ included in the error pattern e_{A} to determine the error positions X₁ and X₂. The arithmetic operation X=X^+s₁ for adding s₁ to the post-transformation position X^ corresponds to the variable inverse transformation.
- Determine the third error position X₃ from X₃=X₁+X₂+s₁.

Also in the LUT 121-2, one piece of key information β acquired by the variable transformation is used. Therefore, the data amount in the table can be reduced as compared with a simple method in which the syndrome is directly used as the key information. In addition, in the present embodiment, although one LUT 121-2 having a large size is used, circuits for multiplication in the subsequent stage of the LUT (arithmetic circuits 131 and 132 in the first embodiment) are not required. Since only circuits for addition (arithmetic circuits 113-2, 114-2, 115, and 116) are used in the subsequent stage of the LUT, a simpler configuration can be obtained.

Hereinafter, details of a method of reducing the data amount in the table ψ will be further described. Examples of the method of reducing the data amount include the following (DM1) to (DM3).

(DM1) Calculate the error patterns of the remaining entries from the error pattern included in one of the entries.

(DM2) Calculate one out of three error positions from the remaining two error positions. For example, it is a method that calculates the error position X₃ from the arithmetic operation using the error positions X₁ and X₂ as illustrated above. With this calculation, the data amount of one error pattern (pattern including a combination of two error positions) is reduced to 2m bits. Moreover, by setting only one error position X₁, the data amount of one error pattern can be m bits. In this case, X₂ and X₃ are determined by using an algorithm (for example, the processing in step S106 in FIG. 3) for calculating an error pattern in a case of the number of errors being two, by using syndromes s'₁=s₁-X₁ and s'₃=s₃-X₁ determined by removing the contribution of the error position X₁ included in the error pattern to the syndrome, from the syndromes s₁ and s₃.

(DM3) For each entry, calculate the remaining error patterns from one of error patterns included in the entry.

Hereinafter, a method of reducing the amount of data will be described by using an example a table for a BCH code whose correction capability is two (t=2) on each of GF(2⁴), GF(2⁵), and GF(2¹⁰).

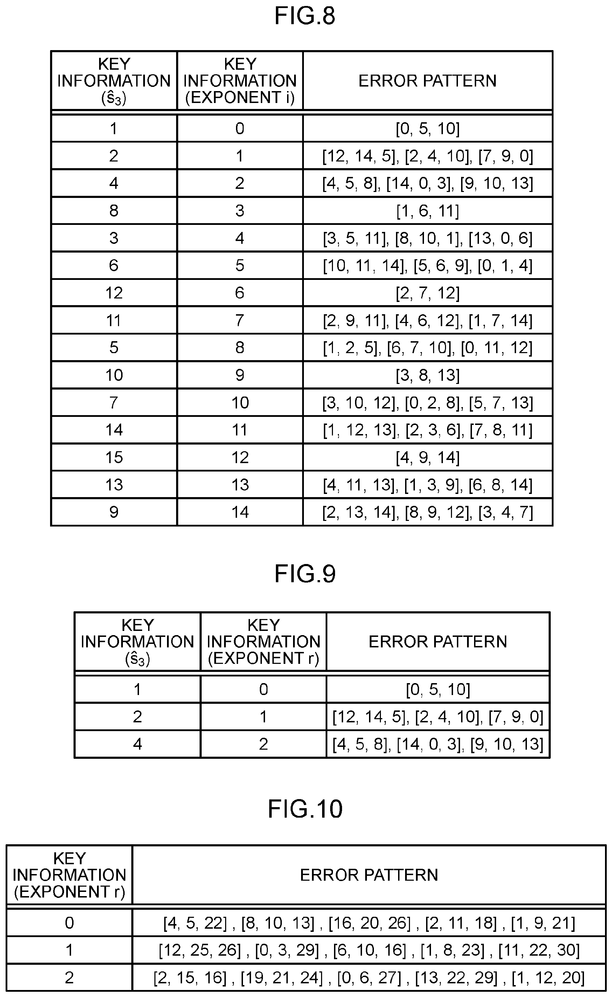

First, an example of using the method (DM1) to determine a table with a reduced data amount on GF(2⁴) will be described. FIG. 8 is a diagram illustrating an example of a table in a case of the primitive polynomial being p(x)=1+x+x⁴. FIG. 8 corresponds to a table before the data amount is reduced. Note that this table corresponds to a table in a case of the affine transformation X^=X+s₁ being used as in the second embodiment.

Two types of key information, s^₃ and exponent i, are illustrated in FIG. 8, but either one may be used as the key information. The value of s^₃ in FIG. 8 corresponds to an integer value of a binary string of s^₃. The error pattern corresponds to the one or more error patterns including the combination of the post-transformation positions (X^₁, X^₂, X^₃). Note that, in FIG. 8, error patterns including a combination of three post-transformation positions are illustrated for convenience of description. In addition, the values of the post-transformation positions in FIG. 8 are represented by values of exponents when the post-transformation positions (X^₁, X^₂, X^₃) are expressed by an exponentiation of α.

There is regularity in the intervals between the three exponents corresponding to the three post-transformation positions. For example, the three intervals for the three exponents of the entry in the first line of FIG. 8 are specified as follows.
- Between the first and second exponents: The interval from 0 to 5 is 5.
- Between the second and third exponents: The interval from 5 to 10 is 5.
- Between the third and first exponents: The interval from 10 to 0 is 5.

Note that the interval from 10 to 0 can be calculated as a value from 10 to 15 by using a value of "15" that is obtained by adding, to "0", the number of entries "15" in FIG. 8. This is because the elements on GF(2⁴) circulate as α¹⁵=α⁰=1.

The combination of the intervals between the exponents as described above is hereinafter referred to as (5,5,5). In the table of FIG. 8, there are three types of combinations of the intervals between the exponents: (5,5,5), (2,6,7), and (1,3,11). Hereinafter, the types of these combinations are referred to as types TA, TB, and TC, respectively. The types TA, TB, and TC, and the exponent i as the key information correspond to each other as follows.
- Type TA=(5,5,5): Exponent i=0, 3, 6, 9, 12
- Type TB=(2,6,7): Exponent i=1, 4, 7, 10, 13
- Type TC=(1,3,11): Exponent i=2, 5, 8, 11, 14

It can be seen that the type TA corresponds to the index i being 3q, where q=0,1,2,3, and 4, the type TB corresponds to the index i being 3q+1, where q=0,1,2,3, and 4, and the type TC corresponds to the index i being 3q+2, where q=0,1,2,3, and 4. From a further closer look at FIG. 8, it is found that each type of error pattern is obtained by adding q to each element of the pattern with q=0. For example, the error pattern (1,6,11) with the exponent i=3 is obtained by adding q=1 to each element of the error pattern (0,5,10) with the exponent i=0. Since the pattern with q=1 and subsequent patterns can be obtained by using the value q=0 in this manner, the number of entries in the table can be reduced to three, 15÷5=3 (corresponding to r=0, 1, and 2). FIG. 9 is a diagram illustrating an example of the table ψ after the number of entries is reduced. In the first embodiment, such a reduction in the data amount (the number of entries) is implemented by setting A=α^{-q}.

The type TB and the type TC correspond to the exponent i with which three error patterns are correlated. The remaining error patterns can be calculated from one out of these three error patterns. This calculation corresponds to the above method (DM3).

The exponent i=1 (type TB) is correlated with the following three error patterns.
- (12,14,5)
- (2,4,10)
- (7,9,0)

The interval between the elements (12, 2, and 7) at the head of the above-noted three error patterns is 5. Therefore, the other two error patterns can be calculated from one error pattern by using the rule that the interval is 5. In this case, the table ψ can be configured to correlate, instead of the three error patterns, information indicating the type (for example, two bits) and one error pattern with the exponent r. Thus, the data amount in the table ψ can be reduced.

The method (DM3) will be further described. Consider an error polynomial e(x) where the syndrome s^₁ after variable transformation is 0. Note that the error polynomial e(x) means an error vector instead of an error position polynomial. The syndrome s^₁ is a value e(α) obtained by substituting α into the error polynomial. Therefore, if s^₁=e(α)=0, e(x) has a minimum polynomial of α, M₁(x)=p(x), as a factor. That is, the polynomial can be defined by e(x)=M₁(x)×q(x) mod x¹⁵+1. From such an error polynomial, the error pattern of the table ψ can be rewritten as follows, for example. Note that an example in which the error patterns corresponding to the exponents r=0, 1, and 2 are rewritten will be described below.
- Exponent r=0: M₁(x)(1+x+x²)(1+x³+x⁴)
- Exponent r=1: (M₁(x))²x¹², (M₁(x))²x², and (M₁(x))²x⁷
- Exponent r=2: M₁(x)x⁴, M₁(x)x¹⁴, and M₁(x)x⁹

In this manner, each error pattern includes the factor of M₁(x). In addition, the entries with the exponents r=1 and 2 each include three error polynomials. The remaining two error polynomials can be calculated by multiplying the first error polynomial among the three error polynomials by a constant.

In a case where, for example, the exponent r=1 and e₁(x)=((M₁(x))²x¹², the following are obtained. ${x}^{5} {e}_{1} \left(x\right) = \left({\left({M}_{1}\left(x\right)\right)}^{2} {x}^{2} mod {x}^{15}+1\right.$ ${x}^{10} {e}_{1} \left(x\right) = \left({\left({M}_{1}\left(x\right)\right)}^{7} {x}^{7} mod {x}^{15}+1\right.$

Therefore, it suffices to store only one representative error polynomial in the table ψ.As a result, the data amount in the table ψ can be reduced.

Next, the table ψ on GF(2⁵) will be described. FIG. 10 is a diagram illustrating an example of the table ψ in a case of the primitive polynomial being p(x)=1+x²+x⁵. In FIG. 10, only the exponent r is indicated as the key information. The exponent r is any of 0, 1, and 2.

Five error patterns with the exponent r=0 are expressed by an error polynomial as follows.
M₁(x)x⁴q₁(x), M₁(x)x⁸, ((M₁(x))²x¹⁶, M₁(x)x²q₂(x), and ((M₁(x))⁴x

Note that M₁(x)=p(x), and q₁(x) and q₂(x) are defined as follows. ${q}_{1} \left(x\right) = 1 + x + {x}^{2} + {x}^{3} + {x}^{4} + {x}^{7} + {x}^{8} + {x}^{10} + {x}^{13}$ ${q}_{2} \left(x\right) = 1 + {x}^{2} + {x}^{4} + {x}^{5} + {x}^{6} + {x}^{8} + {x}^{11}$

Here, it is assumed that the five polynomials corresponding to the exponent r=0 are e₁(x), e₂(x), e₃(x), e₄(x), and e₅(x) in this order. By using these polynomials, the error patterns with the exponents r=0, 1, and 2 are represented as follows.
- Exponent r=0: e₁(x), e₂(x), e₃(x), e₄(x), and e₅(x)
- Exponent r=1: e₁(x)x²¹, e₂(x)x²¹, e₃(x)x²¹, e₄(x)x²¹, and e₅(x)x²¹
- Exponent r=2: e₁(x)x¹¹, e₂(x)x¹¹, e₃(x)x¹¹, e₄(x)x¹¹, and e₅(x)x¹¹

Thus, the error patterns with the exponents r=1 and r=2 can be generated by multiplying the error pattern with the exponent r=0 by a constant. Therefore, it suffices to store only the error pattern of the index r=0 in the table ψ. In this manner, for the table ψ on GF(2⁵), the data amount in the table ψ can be reduced by the above method (DM1).

Note that, also for GF(2⁶) and subsequent GFs, there is a similar regularity. Therefore, the data amount in the table ψ can be reduced by using this regularity. For example, when m of GF(2^{m}) is an even number, the cube root of 1 is included in the element, and thus the following error polynomial exists. Note that "^" in the following formula represents an exponentiation of the value in the parenthesis on the right side of "^". $1 + {x}^{∧} \left(\left({2}^{m}-1\right)/3\right) + {x}^{∧} \left(2\left({2}^{m}-1\right)/3\right)$

In addition, a polynomial obtained by multiplying α^((2^{m}-1)/3) and α^(2(2^{m}-1)/3) appears for a plurality of entries. Therefore, the other error patterns can be calculated from one error pattern.

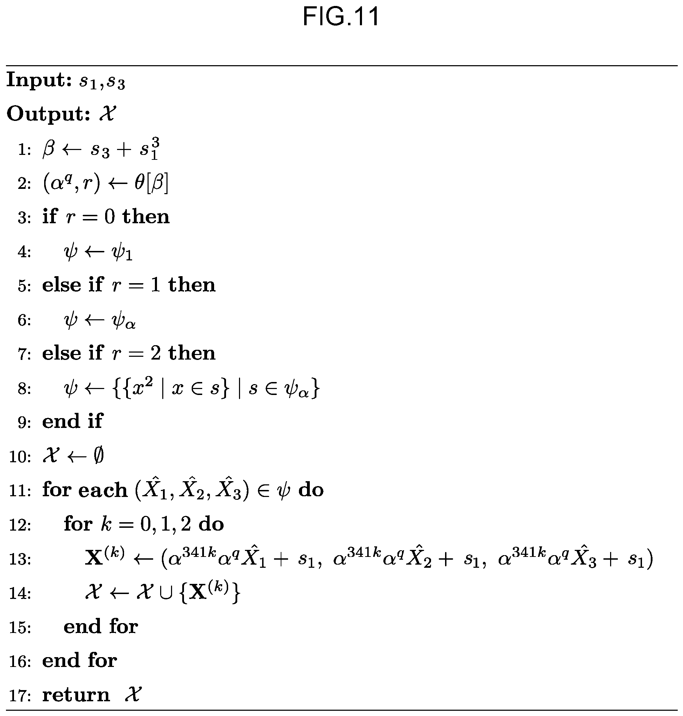

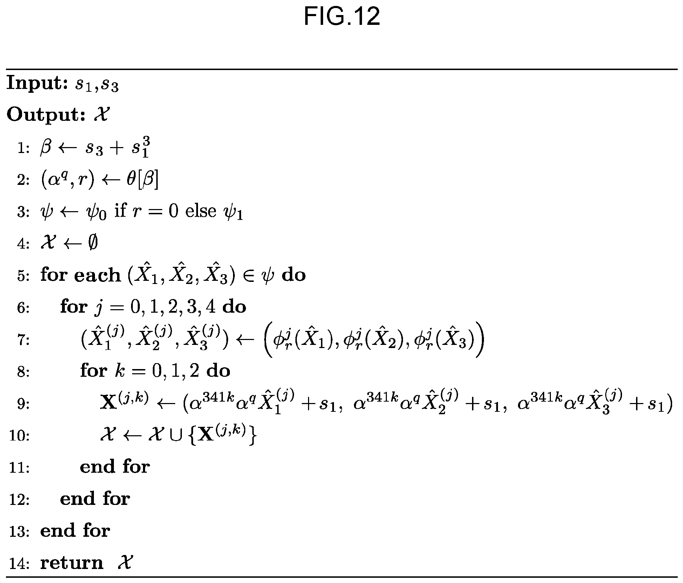

Next, the table ψ on GF(2¹⁰) will be described. The primitive polynomial is defined as p(x)=1+x+x²+x³+x⁵+x⁶-Fx¹⁰. The number of error patterns corresponding to the exponents r=0, 1, and 2 are 181, 165, and 165, respectively. Since three different error polynomials can be generated by using multiplication by the cube root, the number of error patterns stored in the table ψ can be one-third of the above. Specifically, the number of error patterns can be 61, 55, and 55. The reason for the number "61" as to the table for r=0 is as follows. The original number "181" of error patterns for r=0 include an error pattern in which error positions are invariable at 341 intervals even by multiplication of α^341 and α^682. The one-third (÷3) described above is performed after eliminating such an error pattern from the original number "181" of error patterns (i.e., 181-1=180). As a result, the number "61" is derived by 180÷3+1. The table for r=2 is equivalent to squared error patterns of the table for r=1. Therefore, it is sufficient for the table ψ to contain only r=0 and r=1. An exemplary pseudo code of a specific algorism using the tables for r=0 and r=1 is illustrated in FIG. 11. Moreover, the 61 error patterns and the 55 error patterns can be generated by arithmetic operations using 13 error patterns and 11 error patterns, respectively. FIG. 12 illustrates an exemplary pseudo code of a specific algorism for such arithmetic operations. In FIG. 12, Φ^{j}₀ and Φ^{j}₁ are defined by Φ^{j}₀(x)=x^(2^{j}) and Φ^{j}₁=α^((1-4^{j})/3)x^(4^{j}), respectively. Five patterns are generated by Φ^{j}₀ for each of 12 error patterns out of the 13 error patterns, and thereby 61 error patterns are obtained (12×5+1=61). Similarly, five patterns are generated by Φ^{j}₁ for each of the 11 error patterns, and thereby 55 error patterns are obtained (11×5=55). Thereafter, the 181 error patterns or the 165 error patterns described above are generated by multiplication of 1, α^341 and α^682. Therefore, the arithmetic operations of Φ^{j}₀ and Φ^{j}₁ enable the number of the error patterns stored in the table ψ to be 13 and 11, respectively. Note that the arithmetic operations of Φ^{j}₀ and Φⁱ₁ are each an example of arithmetic operation on GF(2¹⁰), and another arithmetic operation will be required for another size of Galois field (GF).

As described above, in the present embodiment, it is possible to characterize (identify) the error position based on only one piece of key information, by using variable transformation. That is, the number of entries in the lookup table can be reduced, and the data amount in the lookup table can be reduced. Moreover, in the present embodiment, the data amount in the lookup table can be further reduced by utilizing the fact that the error polynomials have a common factor when the error patterns are expressed by the error polynomials.

As described above, according to the first and second embodiments, error correction (decoding) can be executed with a simpler configuration.

Various embodiments are in accordance with the following numbered clauses.
Clause 1. A memory system (1) comprising:
   a memory (20) configured to store data having been encoded with an error-correcting code for correcting an error of t bits or less (t is an integer of 2 or more); and
   a controller (10) configured to
      read a received word from the memory (20),
      calculate at least t syndromes by using the read received word,
      calculate, by executing variable transformation on the calculated syndrome, (t-1) pieces of key information for determining one or more first error patterns each including a combination of post-transformation positions, the post-transformation positions being acquired by applying the variable transformation to error positions in a case of the number of error bits being (t+1),
      determine the one or more first error patterns corresponding to the calculated key information by using correspondence information in which possible values for the key information and the one or more first error patterns are correlated with each other,
      calculate the error positions by executing variable inverse transformation on the post-transformation positions included in each of the one or more first error patterns,
      determine a list including one or more second error patterns, the second error patterns each including a combination of the calculated error positions, and
      execute list decoding by using the list.
Clause 2. The memory system (1) according to clause 1, wherein
   t is 2,
   the t syndromes include
      a syndrome s₁ corresponding to a sum of first powers of a primitive element of a Galois field, and
      a syndrome s₃ corresponding to a sum of cubes of the primitive element, and
   the controller is configured to calculate, by executing the variable transformation on the syndrome s₁ and the syndrome s₃, one piece of key information for determining the one or more first error patterns each including three error positions.
Clause 3. The memory system (1) according to clause 2, wherein
   the variable transformation is an affine transformation.
Clause 4. The memory system (1) according to clause 3, wherein,
   when the error position is represented by X, the post-transformation position is represented by X^, and β=s₁³+s₃=α^{3q+r} is defined (q and r are each an integer of 0 or more),
   the affine transformation is defined by X^=AX+B, A=α^{-q}, and B=As₁,
   the key information is r, and
   the controller (10) is configured to determine the error position X by the variable inverse transformation defined by X=(X^+B)/A=α^{q}×X^+s₁.
Clause 5. The memory system (1) according to clause 3, wherein,
   when the error position is represented by X and the post-transformation position is represented by X^,
   the affine transformation is defined by X^=X+s₁,
   the key information is β=s₁³+s₃, and
   the controller (10) is configured to determine the error position X by the variable inverse transformation defined by X=X^+s₁.
Clause 6. The memory system (1) according to any of clauses 2 to 5, wherein
   the controller (10) is configured to, when the number of errors is two or three,
   determine the list including one error pattern including a combination of the error positions in a case of the number of errors being two, in addition to the one or more first error patterns each including a combination of three error positions.
Clause 7. The memory system (1) according to clause 2, wherein
   t is 2,
   the t syndromes include
      a syndrome s₁ corresponding to a sum of first powers of a primitive element of a Galois field,
      a syndrome s₃ corresponding to a sum of cubes of the primitive element, and
      a syndrome s₀ that is 0 when the number of errors is an even number, and
   the controller (10) is configured to
      determine, by using the syndrome s₀, whether or not the number of errors is two, and,
      in response to determining that the number of errors is not two, determine the list including the one or more first error patterns each including a combination of three error positions.
Clause 8. The memory system (1) according to any of clauses 1 to 7, wherein
   the controller (10) is configured to
   select, from among the second error patterns included in the list, the second error pattern having a higher reliability of the error position than the other second error patterns, and
   correct an error of an error position included in the selected second error pattern.
Clause 9. The memory system (1) according to any of clauses 1 to 8, wherein
   the memory (20) and the controller (10) are connected by an interface compliant to a toggle double data rate (Toggle DDR) standard.
Clause 10. The memory system (1) according to any of clauses 1 to 8, wherein
   the memory (20) and the controller (10) are connected by an interface compliant to an open NAND flash interface (ONFI) standard.
Clause 11. A controller (10) comprising:
   a processor (11); and
   a memory interface (13) configured to connect the processor (11) and a memory (20) in which data having been encoded with an error-correcting code for correcting an error of t bits or less (t is an integer of 2 or more) is stored, wherein the processor (11) is configured to
      read a received word from the memory (20) via the memory interface (13),
      calculate at least t syndromes by using the read received word,
      calculate, by executing variable transformation on the calculated syndrome, (t-1) pieces of key information for determining one or more first error patterns each including a combination of post-transformation positions, the post-transformation positions being acquired by applying the variable transformation to error positions in a case of the number of error bits being (t+1),
      determine the one or more first error patterns corresponding to the calculated key information by using correspondence information in which possible values for the key information and the one or more first error patterns are correlated with each other,
      calculate the error positions by executing variable inverse transformation on the post-transformation positions included in each of the one or more first error patterns,
      determine a list including one or more second error patterns, the second error patterns each including a combination of the calculated error positions, and
      execute list decoding by using the list.
Clause 12. The controller (10) according to clause 11, wherein
   t is 2,
   the t syndromes include
      a syndrome s₁ corresponding to a sum of first powers of a primitive element of a Galois field, and
      a syndrome s₃ corresponding to a sum of cubes of the primitive element, and
   the processor (11) is configured to calculate, by executing the variable transformation on the syndrome s₁ and the syndrome s₃, one piece of key information for determining the one or more first error patterns each including three error positions.
Clause 13. The controller (10) according to clause 12, wherein the variable transformation is an affine transformation.
Clause 14. The controller (10) according to clause 13, wherein,
   when the error position is represented by X, the post-transformation position is represented by X^, and β=s₁³+s₃=α^{3q+r} is defined (q and r are each an integer of 0 or more),
   the affine transformation is defined by X^=AX+B, A=α^{-q}, and B=As₁,
   the key information is r, and
   the processor (11) is configured to determine the error position X by the variable inverse transformation defined by X=(X^+B)/A=α^{q}×X^+s₁.
Clause 15. A computer-implemented method of controlling a memory (20), the method comprising:
   storing, in the memory (20), data having been encoded with an error-correcting code for correcting an error of t bits or less (t is an integer of 2 or more);
   reading a received word from the memory (20);
   calculating at least t syndromes by using the read received word;
   calculating, by executing variable transformation on the calculated syndrome, (t-1) pieces of key information for determining one or more first error patterns each including a combination of post-transformation positions, the post-transformation positions being acquired by applying the variable transformation to error positions in a case of the number of error bits being (t+1);
   determining the one or more first error patterns corresponding to the calculated key information by using correspondence information in which possible values for the key information and the one or more first error patterns are correlated with each other;
   calculating the error positions by executing variable inverse transformation on the post-transformation positions included in each of the one or more first error patterns;
   determining a list including one or more second error patterns, the second error patterns each including a combination of the calculated error positions; and
   executing list decoding by using the list.

While certain embodiments have been described, these embodiments have been presented by way of example only, and are not intended to limit the scope of the inventions. Indeed, the novel embodiments described herein may be embodied in a variety of other forms; moreover, various omissions, substitutions and changes in the form of the embodiments described herein may be made without departing from the inventions. The accompanying claims are intended to cover such forms or modifications as would fall within the scope of the inventions.

## Claims

1. A memory system (1) comprising:
a memory (20) configured to store data having been encoded with an error-correcting code for correcting an error of t bits or less (t is an integer of 2 or more); and
a controller (10) configured to
read a received word from the memory (20),
calculate at least t syndromes by using the read received word,
calculate, by executing variable transformation on the calculated syndrome, (t-1) pieces of key information for determining one or more first error patterns each including a combination of post-transformation positions, the post-transformation positions being acquired by applying the variable transformation to error positions in a case of the number of error bits being (t+1),
determine the one or more first error patterns corresponding to the calculated key information by using correspondence information in which possible values for the key information and the one or more first error patterns are correlated with each other,
calculate the error positions by executing variable inverse transformation on the post-transformation positions included in each of the one or more first error patterns,
determine a list including one or more second error patterns, the second error patterns each including a combination of the calculated error positions, and
execute list decoding by using the list.

2. The memory system (1) according to claim 1, wherein
t is 2,
the t syndromes include
a syndrome s₁ corresponding to a sum of first powers of a primitive element of a Galois field, and
a syndrome s₃ corresponding to a sum of cubes of the primitive element, and
the controller is configured to calculate, by executing the variable transformation on the syndrome s₁ and the syndrome s₃, one piece of key information for determining the one or more first error patterns each including three error positions.

3. The memory system (1) according to claim 2, wherein
the variable transformation is an affine transformation.

4. The memory system (1) according to claim 3, wherein,
when the error position is represented by X, the post-transformation position is represented by X^, and β=s₁³+s₃=α^{3q+r} is defined (q and r are each an integer of 0 or more),
the affine transformation is defined by X^=AX+B, A=α^{-q}, and B=As₁,
the key information is r, and
the controller (10) is configured to determine the error position X by the variable inverse transformation defined by X=(X^+B)/A=α^{q}×X^+s₁.

5. The memory system (1) according to claim 3, wherein,
when the error position is represented by X and the post-transformation position is represented by X^,
the affine transformation is defined by X^=X+s₁,
the key information is β=s₁³+s₃, and
the controller (10) is configured to determine the error position X by the variable inverse transformation defined by X=X^+s₁.

6. The memory system (1) according to any of claims 2 to 5, wherein
the controller (10) is configured to, when the number of errors is two or three,
determine the list including one error pattern including a combination of the error positions in a case of the number of errors being two, in addition to the one or more first error patterns each including a combination of three error positions.

7. The memory system (1) according to claim 2, wherein
t is 2,
the t syndromes include
a syndrome s₁ corresponding to a sum of first powers of a primitive element of a Galois field,
a syndrome s₃ corresponding to a sum of cubes of the primitive element, and
a syndrome s₀ that is 0 when the number of errors is an even number, and
the controller (10) is configured to
determine, by using the syndrome s₀, whether or not the number of errors is two, and,
in response to determining that the number of errors is not two, determine the list including the one or more first error patterns each including a combination of three error positions.

8. The memory system (1) according to any of claims 1 to 7, wherein
the controller (10) is configured to
select, from among the second error patterns included in the list, the second error pattern having a higher reliability of the error position than the other second error patterns, and
correct an error of an error position included in the selected second error pattern.

9. The memory system (1) according to any of claims 1 to 8, wherein
the memory (20) and the controller (10) are connected by an interface compliant to a toggle double data rate (Toggle DDR) standard.

10. The memory system (1) according to any of claims 1 to 8, wherein
the memory (20) and the controller (10) are connected by an interface compliant to an open NAND flash interface (ONFI) standard.

11. A controller (10) comprising:
a processor (11); and
a memory interface (13) configured to connect the processor (11) and a memory (20) in which data having been encoded with an error-correcting code for correcting an error of t bits or less (t is an integer of 2 or more) is stored, wherein
the processor (11) is configured to
read a received word from the memory (20) via the memory interface (13),
calculate at least t syndromes by using the read received word,
calculate, by executing variable transformation on the calculated syndrome, (t-1) pieces of key information for determining one or more first error patterns each including a combination of post-transformation positions, the post-transformation positions being acquired by applying the variable transformation to error positions in a case of the number of error bits being (t+1),
determine the one or more first error patterns corresponding to the calculated key information by using correspondence information in which possible values for the key information and the one or more first error patterns are correlated with each other,
calculate the error positions by executing variable inverse transformation on the post-transformation positions included in each of the one or more first error patterns,
determine a list including one or more second error patterns, the second error patterns each including a combination of the calculated error positions, and
execute list decoding by using the list.

12. The controller (10) according to claim 11, wherein
t is 2,
the t syndromes include
a syndrome s₁ corresponding to a sum of first powers of a primitive element of a Galois field, and
a syndrome s₃ corresponding to a sum of cubes of the primitive element, and
the processor (11) is configured to calculate, by executing the variable transformation on the syndrome s₁ and the syndrome s₃, one piece of key information for determining the one or more first error patterns each including three error positions.

13. The controller (10) according to claim 12, wherein
the variable transformation is an affine transformation.

14. The controller (10) according to claim 13, wherein,
when the error position is represented by X, the post-transformation position is represented by X^, and β=s₁³+s₃=α^{3q+r} is defined (q and r are each an integer of 0 or more),
the affine transformation is defined by X^=AX+B, A=α^{-q}, and B=As₁,
the key information is r, and
the processor (11) is configured to determine the error position X by the variable inverse transformation defined by X=(X^+B)/A=α^{q}×X^+s₁.

15. A computer-implemented method of controlling a memory (20), the method comprising:
storing, in the memory (20), data having been encoded with an error-correcting code for correcting an error of t bits or less (t is an integer of 2 or more);
reading a received word from the memory (20);
calculating at least t syndromes by using the read received word;
calculating, by executing variable transformation on the calculated syndrome, (t-1) pieces of key information for determining one or more first error patterns each including a combination of post-transformation positions, the post-transformation positions being acquired by applying the variable transformation to error positions in a case of the number of error bits being (t+1);
determining the one or more first error patterns corresponding to the calculated key information by using correspondence information in which possible values for the key information and the one or more first error patterns are correlated with each other;
calculating the error positions by executing variable inverse transformation on the post-transformation positions included in each of the one or more first error patterns;
determining a list including one or more second error patterns, the second error patterns each including a combination of the calculated error positions; and
executing list decoding by using the list.

## Amended claims

### Amended claims in accordance with Rule 137(2) EPC.

1. A controller (10) comprising:
a processor (11); and
a memory interface (13) configured to connect the processor (11) and a memory (20) in which data having been encoded with an error-correcting code for correcting an error of two bits or less is stored; and
the processor (11) is configured to
read a received word from the memory (20) via the memory interface (13),
calculate at least two syndromes by using the read received word, each of the two syndromes being defined by variables that are elements on a Galois field,
calculate, by executing variable transformation on the calculated two syndromes, one piece of key information,
determine one or more first error patterns corresponding to the calculated key information by using correspondence information in which possible values for the key information and the one or more first error patterns are correlated with each other, the one or more first error patterns each including a combination of post-transformation positions, the post-transformation positions being acquired by applying the variable transformation to error positions in a case of the number of error bits being three, the error positions being defined by the variables,
calculate the error positions by executing variable inverse transformation on the post-transformation positions included in each of the one or more first error patterns,
determine a list including one or more second error patterns, the second error patterns each including a combination of the calculated error positions, and
execute list decoding by using the list, wherein
the two syndromes include
a syndrome s₁ corresponding to a sum of first powers of a primitive element of the Galois field, and
a syndrome s₃ corresponding to a sum of cubes of the primitive element,
the processor (11) is configured to calculate, by executing the variable transformation on the syndrome s₁ and the syndrome s₃, the key information for determining the one or more first error patterns each including three error positions,
the variable transformation is an affine transformation,
when the error position is represented by X, the post-transformation position is represented by X^, and β=s₁³+s₃=α^{3q+r} is defined, q and r each being an integer of 0 or more,
the affine transformation is defined by X^=AX+B, A=α^{-q}, and B=As₁, the key information is r, and
the processor (11) is configured to determine the error position X by the variable inverse transformation defined by X=(X^+B)/A=α^{q}×X^+s₁.

2. The controller (10) according to claim 1, wherein
the processor (11) is configured to, when the number of errors is two or three,
determine the list including one error pattern including a combination of the error positions in a case of the number of errors being two, in addition to the one or more first error patterns each including a combination of three error positions.

3. The controller (10) according to claim 1, wherein
the two syndromes further include
a syndrome s₀ that is 0 when the number of errors is an even number, and
the processor (11) is configured to
determine, by using the syndrome s₀, whether or not the number of errors is two, and,
in response to determining that the number of errors is not two, determine the list including the one or more first error patterns each including a combination of three error positions.

4. The controller (10) according to any of claims 1 to 3, wherein
the processor (11) is configured to
select, from among the second error patterns included in the list, the second error pattern having a higher reliability of the error position than the other second error patterns, and
correct an error of an error position included in the selected second error pattern.

5. The controller (11) according to any of claims 1 to 4, wherein
the memory interface (13) is an interface compliant to a toggle double data rate (Toggle DDR) standard.

6. The memory system (1) according to any of claims 1 to 5, wherein
the memory interface (13) is an interface compliant to an open NAND flash interface (ONFI) standard.

7. A memory system (1) comprising:
the controller (10) according to any one of claim 1 to 6.

8. A computer-implemented method of controlling a memory (20), the method comprising:
storing, in the memory (20), data having been encoded with an error-correcting code for correcting an error of two bits or less;
reading a received word from the memory (20);
calculating at least two syndromes by using the read received word, each of the two syndromes being defined by variables that are elements on a Galois field;
calculating, by executing variable transformation on the calculated two syndromes, one piece of key information;
determining one or more first error patterns corresponding to the calculated key information by using correspondence information in which possible values for the key information and the one or more first error patterns are correlated with each other, the one or more first error patterns each including a combination of post-transformation positions, the post-transformation positions being acquired by applying the variable transformation to error positions in a case of the number of error bits being three, the error positions being defined by the variables;
calculating the error positions by executing variable inverse transformation on the post-transformation positions included in each of the one or more first error patterns;
determining a list including one or more second error patterns, the second error patterns each including a combination of the calculated error positions; and
executing list decoding by using the list, wherein
the two syndromes include
a syndrome s₁ corresponding to a sum of first powers of a primitive element of the Galois field, and
a syndrome s₃ corresponding to a sum of cubes of the primitive element,
calculating the key information includes calculating, by executing the variable transformation on the syndrome s₁ and the syndrome s₃, the key information for determining the one or more first error patterns each including three error positions,
the variable transformation is an affine transformation,
when the error position is represented by X, the post-transformation position is represented by X^, and β=s₁³+s₃=α^{3q+r} is defined, q and r each being an integer of 0 or more,
the affine transformation is defined by X^=AX+B, A=α^{-q}, and B=As₁, the key information is r, and
the method further comprising:
determining the error position X by the variable inverse transformation defined by X=(X^+B)/A=α^{q}×X^+s₁.
